# DEMANDE DE BREVET EUROPEEN

(11) **EP 3 892 755 A1**
(43) Date de publication de la demande: **13.10.2021**
(21) Numéro de dépôt: 21166849.6
(22) Date de dépôt: 02.04.2021
(51) Int. Cl.: C23C 16/455, C01G 41/00, C23C 16/02, C23C 16/06

(54) **PROCEDE DE DEPOT D'UN FILM METALLIQUE DE MOLYBDENE PAR ALD**

(30) Priorité: 07.04.2020 FR 2003447
(71) Demandeur: Commissariat à l'énergie atomique et aux énergies alternatives, 75015 Paris (FR)
(72) Inventeur: CADOT, Stéphane, 38000 GRENOBLE (FR)
(74) Mandataire: Brevalex

(57) **Abrégé**

Procédé de dépôt comprenant les étapes successives suivantes :
- fournir un substrat (10) dans un réacteur de dépôt par ALD,
- former un film métallique (20) en molybdène, sur le substrat (10), par ALD, en réalisant plusieurs fois un cycle de dépôt comprenant les étapes suivantes :
a) introduire dans le réacteur un flux contenant un gaz inerte et un précurseur du métal Mo(PF₃)₆,
le substrat (10) étant porté à une première température inférieure à la température de décomposition thermique du précurseur du métal,
b) purger le réacteur,
c) introduire dans le réacteur un flux d'un co-réactant, le co-réactant étant de l'hydrogène ou un plasma d'hydrogène, le substrat (10) étant porté à une seconde température inférieure à 500°C et supérieure ou égale à la première température,
d) purger le réacteur.

## Description

### DOMAINE TECHNIQUE

La présente invention se rapporte au domaine général des films métalliques de tungstène ou de molybdène, par exemple pour la fabrication d'électrodes ou d'interconnexions métalliques, notamment pour la technologie CMOS.

L'invention concerne un procédé de dépôt d'un film métallique de tungstène ou de molybdène, sur un substrat pouvant être en silicium.

### ÉTAT DE LA TECHNIQUE ANTÉRIEURE

Jusqu'à présent, les interconnexions métalliques étaient principalement en cuivre, en raison de sa très faible résistivité (1,7 µΩ.cm).

Néanmoins, de nos jours, dans le domaine des technologies avancées, les dimensions des dispositifs, et donc des interconnexions métalliques, sont de plus en plus réduites. Or, la miniaturisation des interconnexions en cuivre conduit à une augmentation considérable de leur résistivité. L'utilisation de métaux alternatifs est donc nécessaire.

Dans la plupart des dispositifs semi-conducteurs avancés, les interconnexions en tungstène se sont révélées être une alternative efficace au cuivre, bien que les techniques de dépôt mises en œuvre actuellement ne permettent pas d'obtenir un tungstène dont la résistivité est optimale. Pour adresser ces interconnections de dimensions réduite, le tungstène est typiquement déposé par dépôt chimique en phase vapeur par couches atomiques (ALD) ou par dépôt chimique en phase vapeur (CVD). Le dépôt de tungstène par CVD ou par ALD est principalement basé sur la réaction entre l'hexafluorure de tungstène (WF₆) et l'hydrogène.

Cependant, le principal inconvénient de ce procédé est la formation d'hydrogène fluoré (HF) comme sous-produit de la réaction, qui attaque le substrat lorsqu'il est en silicium, endommageant ainsi le dispositif. Par conséquent, on ajoute souvent, sur le substrat, une couche barrière, par exemple en nitrure de titane (TiN), recouverte d'une couche de nucléation à base de silane (SiH₄) ou de diborane (B₂H₆). Alternativement, du sulfure de zinc (ZnS) peut être déposé par ALD en utilisant du diéthylzinc (DEZ) et du sulfure d'hydrogène (H₂S) pour servir à la fois de barrière de diffusion au fluor et de couche de nucléation pour le tungstène.

Un autre inconvénient du procédé WF₆/H₂ est la présence de fluor résiduel lorsque le dépôt n'est pas réalisé à une température suffisamment élevée, ce qui a un impact négatif sur la résistivité du film de tungstène. Pour obtenir un film de tungstène exempt de fluor, des températures de dépôt élevées sont nécessaires (généralement supérieures à 500°C), ce qui pose des problèmes de compatibilité avec les technologies CMOS.

Le dépôt de tungstène à basse température peut être effectué en utilisant des composés organométalliques de tungstène comme l'hexacarbonyltungstène (W(CO)₆). Le procédé classiquement utilisé pour le dépôt de couches minces de tungstène par ALD consiste à alterner des impulsions (« pulses ») de W(CO)₆ et des impulsions de plasma d'hydrogène tout en maintenant le substrat à des températures d'environ 180-200°C. Le film obtenu présente une faible rugosité, mais des valeurs de résistivité relativement élevées (200 µΩ.cm vs. 6 µΩ.cm attendu pour un film exempt d'impuretés), pouvant être principalement attribuées aux inclusions de carbone dans le film de tungstène, suite à la décomposition thermique des ligands carbonyles (CO).

Ces inconvénients précédemment cités peuvent-être évités par le choix d'un précurseur de tungstène ne comprenant pas de liaisons métal-halogène ou métal-carbone. C'est par exemple le cas du complexe W(PF₃)₆, qui dans le document US 3,619,288, est utilisé pour déposer un film de tungstène par CVD. La température de mise en œuvre du procédé est en revanche supérieure à 500°C, ce qui la rend difficilement compatible avec les technologies CMOS.

### EXPOSÉ DE L'INVENTION

Le but de la présente invention est de proposer un procédé de dépôt d'un film de molybdène ou de tungstène de faible résistivité, par exemple pour former des interconnexions métalliques, le procédé devant être mis en œuvre à basse température (typiquement inférieure à 500°C) pour pouvoir être compatible avec les technologies CMOS.

Pour cela, la présente invention propose un procédé de dépôt comprenant les étapes successives suivantes :
- fournir un substrat dans un réacteur de dépôt par ALD,
- former un film métallique de tungstène ou de molybdène, sur le substrat, par ALD, en réalisant plusieurs fois un cycle de dépôt comprenant les étapes suivantes :
   a) introduire dans le réacteur un flux contenant un gaz inerte et un précurseur du métal choisi parmi W(PF₃)₆ et Mo(PF₃)₆, le substrat étant porté à une première température inférieure à la température de décomposition thermique du précurseur du métal,
   b) purger le réacteur,
   c) introduire dans le réacteur un flux d'un co-réactant, le co-réactant étant de l'hydrogène ou un plasma d'hydrogène, le substrat étant porté à une seconde température inférieure à 500°C et supérieure ou égale à la première température,
   d) purger le réacteur.

Le procédé se distingue de l'art antérieur par l'utilisation des complexes volatils Mo(PF₃)₆ ou W(PF₃)₆ au sein d'une séquence de dépôt chimique en phase vapeur par couches atomiques (ou ALD pour « Atomic Layer Deposition »). Le procédé permet la mise en œuvre d'un dépôt métallique conforme dans des cavités à fort facteur de forme, et à des températures inférieures à 500°C.

Lors de la mise en œuvre des précurseurs Mo(PF₃)₆ ou W(PF₃)₆ (étape a), la première température de dépôt est inférieure à 500°C puisque les températures de décomposition de ces précurseurs sont inférieures à 500°C.

Avantageusement, la première température de dépôt est comprise entre 100°C et 500°C.

De préférence, la première température de dépôt est comprise entre 200°C et 280°C lorsque le précurseur du métal est Mo(PF₃)₆ . Avec une telle gamme de température, il n'y a aucune décomposition thermique du précurseur, ce qui permet d'obtenir la meilleure uniformité du dépôt. En dehors de cette gamme, le procédé devient un procédé de type CVD et la qualité du dépôt se dégrade.

De préférence, la première température de dépôt est comprise entre 250°C et 350°C lorsque le précurseur du métal est W(PF₃)₆.

Avantageusement, lors de la mise en œuvre du co-réactant (étape c), la seconde température est comprise entre 100°C et 500°C.

De préférence, le co-réactant est l'hydrogène. L'hydrogène est sous forme gazeuse (H₂). Il peut être injecté pur ou dilué avec un gaz inerte.

Par gaz inerte, on entend de l'azote ou un gaz noble (par exemple l'argon, l'hélium ou le néon). De préférence, on choisira de l'azote pour des raisons de coûts.

On choisira un substrat stable à la première température et à la deuxième température mises en œuvre au cours du procédé.

Selon un mode de réalisation avantageux, le substrat est du silicium, un métal, un oxyde, un nitrure ou un sulfure.

Selon un autre mode de réalisation avantageux, le substrat est un polymère. Il peut s'agir, par exemple, d'un parylène ou d'un polyimide tel que le Kapton®.

Avantageusement, avant de former le film métallique, une couche de nucléation peut être formée à la surface du substrat. La mise en place de cette couche de nucléation est particulièrement pertinente dans le cas où le substrat est hydrophile (c'est-à-dire qu'il présente des liaisons polaires, par exemple de type -OH, à sa surface). Elle peut être formée, par exemple, en exposant la surface du substrat à un agent de nucléation tel qu'un dérivé du silane (afin de former des liaisons Si-H à la surface du substrat).

Avantageusement, le film métallique a une épaisseur allant de 0,5 nm à 200 nm, et de préférence de 2nm à 10 nm.

L'invention concerne également un film métallique obtenu par le procédé précédemment décrit.

Le procédé présente un ou plusieurs des avantages suivants :
- les films métalliques de tungstène ou de molybdène obtenus ont une faible résistivité et une pureté élevée : ils sont dépourvus de résidus de carbone et d'halogène,
- la faible température de dépôt permet d'obtenir des films de tungstène ou de molybdène directement sur silicium sans former de siliciure à l'interface,
- les sous-produits de réaction (principalement PF₃) sont moins corrosifs que ceux libérés dans le cas de précurseurs possédant une liaison métal-halogène (dont la décomposition produit des halogénures d'hydrogène),
- il est particulièrement adapté au dépôt de films minces hautement conformes,
- il est particulièrement adapté au dépôt de films minces dans des architectures à forte topologie.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1 représente schématiquement le mécanisme de dépôt d'une première couche atomique de métal M, sur un substrat, lors du premier cycle ALD, selon un mode de réalisation particulier de l'invention.
La figure 2 représente schématiquement le mécanisme de dépôt d'une deuxième couche atomique de métal M, sur un substrat, lors du second cycle ALD, selon un mode de réalisation particulier de l'invention.
La figure 3 représente, schématiquement une vue en coupe et de profil, d'un empilement comprenant un substrat et un film métallique, selon un mode de réalisation particulier de l'invention.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Bien que cela ne soit aucunement limitatif, l'invention trouve des applications dans de nombreux domaines, notamment dans le domaine de la microélectronique, par exemple pour former sur des substrats, plans ou à forte topologie, des électrodes ou des interconnexions métalliques, faiblement résistives et d'épaisseur conforme pour des dispositifs ultra-miniaturisés (transistors, mémoires flash ou supercondensateurs à haute densité par exemple). L'invention est particulièrement intéressante pour former des contacts métalliques dont la largeur est de l'ordre de la dizaine de nanomètres.

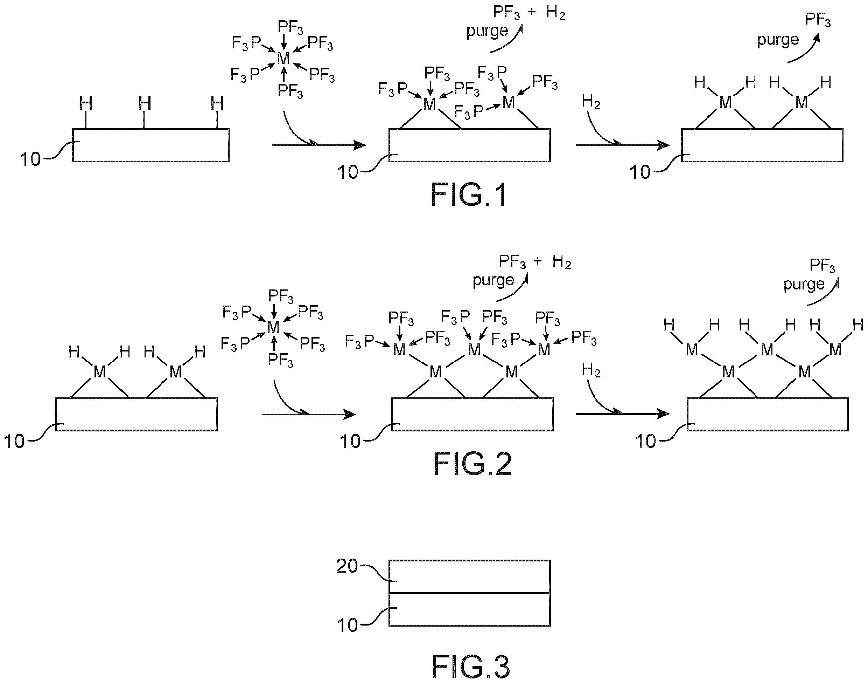

Le procédé de dépôt comprend les étapes successives suivantes :
- fournir un substrat dans un réacteur de dépôt par ALD,
- éventuellement purger le réacteur,
- former un film en métal M sur le substrat, par ALD, en réalisant plusieurs fois un cycle de dépôt comprenant les étapes suivantes (illustrées sur les figures 1 et 2):
   a) introduire dans le réacteur un flux contenant un gaz inerte et un précurseur du métal M de formule générale M(PF₃)₆ avec M correspondant au molybdène ou au tungstène, la première température étant inférieure à la température de décomposition thermique du précurseur du métal,
   b) purger le réacteur,
   c) introduire dans le réacteur un flux d'un co-réactant, le co-réactant étant de l'hydrogène ou un plasma d'hydrogène, le substrat étant porté à une seconde température inférieure à 500°C et supérieure ou égale à la première température,
   d) purger le réacteur.

Lors de l'étape a), le précurseur du métal M est l'hexakis(trifluorophosphine)molybdène (Mo(PF₃)₆) ou l'hexakis(trifluorophosphine)tungstène (W(PF₃)₆).

Lors de l'étape a), le substrat 10 est maintenu à une première température inférieure à la température de décomposition du précurseur du métal. La première température dite de dépôt est inférieure à 500°C, de préférence elle est comprise entre 100°C et 500°C, et encore plus préférentiellement entre 200°C et 350°C pour être à une température inférieure à la température de décomposition du précurseur mis en œuvre.

De préférence, lorsque le précurseur du métal est Mo(PF₃)₆, la première température de dépôt est comprise entre 200°C et 280°C.

De préférence, lorsque le précurseur du métal est W(PF₃)₆, la première température de dépôt est comprise entre 250°C et 350°C.

Pour former un film en alliage de molybdène et de tungstène, on réalisera plusieurs cycles de dépôt, en déposant, lors de l'étape a), soit (Mo(PF₃)₆ soit W(PF₃)₆). On choisira, de préférence, une température de dépôt commune aux deux précurseurs (Mo(PF₃)₆ et W(PF₃)₆), par exemple une température comprise entre 250°C et 280°C.

Le substrat 10 peut être du silicium, un métal, un oxyde, un nitrure ou un sulfure.

Le substrat peut également être un polymère.

On pourra, par exemple, choisir du verre borosilicaté, du quartz, du saphir, un parylène ou un polyimide.

Avant le cycle ALD, la surface du substrat 10 peut être modifiée en réalisant un pré-traitement avec un agent de silanisation, par exemple avec un silane ou un dérivé du silane, de manière à former des liaisons Si-H de surface, jouant le rôle promoteur de nucléation.

Lors de l'étape c), la deuxième température est, de préférence, égale à la première température afin de maximiser la vitesse de dépôt.

Lors de l'étape c), on introduit le second réactif du procédé ALD. L'hydrogène peut être introduit sous forme moléculaire (hydrogène gazeux H₂) ou sous la forme d'un plasma d'hydrogène, pur ou en mélange avec un gaz inerte.

Lors du cycle de dépôt par ALD les précurseurs sont injectés successivement. Le cycle de dépôt peut être répété jusqu'à ce que le film métallique ait l'épaisseur souhaitée, par exemple de 2 nm à 10 nm. Chaque cycle permet de déposer une couche métallique. La superposition des différentes couches métalliques forme un film métallique 20

Les gaz inertes utilisés dans les différentes étapes de purge et/ou lors de l'étape a) et/ou lors de l'étape c) peuvent être identiques ou différents. Avantageusement, il s'agit du même gaz inerte. De préférence, il s'agit de l'azote.

Le réacteur ALD peut être un réacteur sous vide. La pression dans le réacteur ALD, lors du cycle ALD peut aller, par exemple, de 0,1 Torr à 10 Torr. Le cycle ALD peut également être réalisé à la pression atmosphérique (soit environ 760 Torr). Les pressions en ALD ne sont pas un facteur critique. Le choix des pressions dépendra du réacteur ALD utilisé lors du procédé.

A l'issue du procédé, on obtient un film métallique de molybdène et/ou de tungstène faiblement résistif et d'épaisseur uniforme sur toute la surface du substrat (figure 3). L'épaisseur du film métallique déposé peut aller de 0,5 nm à 200 nm.

Un tel procédé est particulièrement intéressant pour former des films métalliques pour le domaine des semi-conducteurs, notamment lorsqu'il s'agit de recouvrir des cavités à fort facteur de forme.

Les faibles températures de mise en œuvre du procédé sont particulièrement adaptées pour le dépôt de couches minces de molybdène ou de tungstène directement sur silicium.

## Revendications

1. Procédé de dépôt comprenant les étapes successives suivantes :
- fournir un substrat (10) dans un réacteur de dépôt par ALD,
- former un film métallique (20) de molybdène, sur le substrat (10), par ALD, en réalisant plusieurs fois un cycle de dépôt comprenant les étapes suivantes :
a) introduire dans le réacteur un flux contenant un gaz inerte et un précurseur du métal, le précurseur du métal étant Mo(PF₃)₆,
le substrat (10) étant porté à une première température inférieure à la température de décomposition thermique du précurseur du métal, la première température étant comprise entre 200°C et 280°C,
b) purger le réacteur,
c) introduire dans le réacteur un flux d'un co-réactant, le co-réactant étant de l'hydrogène ou un plasma d'hydrogène, le substrat (10) étant porté à une seconde température inférieure à 500°C et supérieure ou égale à la première température,
d) purger le réacteur.

2. Procédé selon la revendication 1, **caractérisé en ce que**, lors de l'étape c), l'hydrogène est injecté pur ou dilué dans de l'azote ou dans un gaz inerte.

3. Procédé selon l'une des revendications précédentes 1 et 2, **caractérisé en ce que** le substrat (10) est du silicium, un métal, un oxyde, un nitrure ou un sulfure.

4. Procédé selon l'une des revendications précédentes 1 et 2, **caractérisé en ce que** le substrat (10) est un polymère, par exemple un parylène ou un polyimide.

5. Procédé selon l'une quelconque des revendications précédentes, **caractérisé en ce que**, avant de former le film métallique (20), la surface du substrat (10) est exposée à un agent de nucléation pouvant être un dérivé du silane.

6. Procédé selon l'une quelconque des revendications précédentes, **caractérisé en ce que** la seconde température est comprise entre 100°C et 500°C.

7. Procédé selon l'une quelconque des revendications précédentes, **caractérisé en ce que** le cycle de dépôt est réalisé plusieurs fois jusqu'à obtenir un film métallique (20) de molybdène ayant une épaisseur de 0,5 nm à 200 nm.

8. Procédé selon la revendication précédente, **caractérisé en ce que** le cycle de dépôt est réalisé plusieurs fois jusqu'à obtenir un film métallique (20) de molybdène ayant une épaisseur de 2nm à 10 nm.

9. Film métallique (20) de molybdène obtenu par le procédé selon l'une quelconque des revendications précédentes, **caractérisé en ce qu'**il possède une épaisseur allant de 0,5 nm à 200 nm.

10. Film métallique (20) de molybdène selon la revendication précédente, **caractérisé en ce qu'**il possède une épaisseur allant de 2 nm à 10 nm.
